# FASCICULE DE BREVET EUROPEEN

(11) **EP 4 071 451 B1**
(45) Date de publication et mention de la délivrance du brevet: **04.10.2023**
(21) Numéro de dépôt: 22166771.0
(22) Date de dépôt: 05.04.2022
(51) Int. Cl.: G01L 9/00, G01L 19/00, G01L 19/14

(54) **CAPTEUR DE PRESSION POUR UN CIRCUIT DE FLUIDE OU POUR UNE ENCEINTE ETANCHE DE VEHICULE AUTOMOBILE**
DRUCKSENSOR FÜR EINEN FLUIDKREISLAUF ODER EIN DICHTES GEHÄUSE EINES KRAFTFAHRZEUGS
PRESSURE SENSOR FOR A FLUID CIRCUIT OR FOR A SEALED ENCLOSURE OF A MOTOR VEHICLE

(30) Priorité: 09.04.2021 FR 2103622
(43) Date de publication de la demande: 12.10.2022
(73) Titulaire: HUTCHINSON, 75008 Paris (FR)
(72) Inventeur: GABRIELLE, Brice, 45200 MONTARGIS (FR); BENARD, Thierry, 45430 CHECY (FR)
(74) Mandataire: Gevers & Orès

(56) Documents cités:
- DE-A1- 10 323 297
- US-A1- 2006 144 155
- JOSE G VILLALOBOS ET AL: "IDC based battery-free wireless pressure sensor", 2010 IEEE/ASME INTERNATIONAL CONFERENCE ON MECHATRONIC AND EMBEDDED SYSTEMS AND APPLICATIONS (MESA 2010) IEEE PISCATAWAY, NJ, USA, IEEE, PISCATAWAY, NJ, USA, 15 juillet 2010 (2010-07-15), pages 186-191, XP031734911, ISBN: 978-1-4244-7101-0

## Description

### Domaine technique de l'invention

La présente invention concerne notamment un capteur de pression pour un circuit de fluide ou une enceinte étanche, en particulier d'un véhicule automobile.

### Arrière-plan technique

L'arrière-plan technique comprend notamment les documents US-A1-2006/144155, US-B1-7,146,861 et US-A1-2014/309577. Le document US-A1-2006/144155 divulgue un capteur de pression correspondant au préambule de la revendication 1. La publication "IDC based battery-free wireless pressure sensor", JOSE G VILLALOBOS ET AL, 2010 IEEE/ASME INTERNATIONAL CONFERENCE ON MECHATRONIC AND EMBEDDED SYSTEMS AND APPLICATIONS (MESA 2010), 15 juillet 2010, pages 186-191, divulgue un capteur de pression avec un circuit LC comportant une bobine et un condensateur, le condensateur étant formé par deux électrodes interdigitées. Le document DE 103 23 297 A1 divulgue un capteur de pression à membrane avec un circuit résonant comprenant des bobines et un condensateur. Une des électrodes du condensateur est située sur une face de la membrane et est entourée par une bobine située sur la même face de la membrane.

Un véhicule, en particulier automobile, comprend plusieurs circuits de fluide dont la pression doit être mesurée et contrôlée afin de vérifier en temps réel le bon fonctionnement du véhicule. C'est par exemple le cas du circuit de carburant d'un véhicule.

Un véhicule, en particulier électrique ou hybride, peut en outre comprendre un pack batterie qui comprend une enceinte étanche dans laquelle sont logées des cellules électriques de batterie. Ce pack batterie peut être équipé d'un capteur de pression afin de détecter une montée en pression de l'intérieur de l'enceinte, notamment à cause d'un relargage de gaz d'une cellule qui dysfonctionnerait.

Il existe plusieurs technologies de capteurs de pression. Certains capteurs de pression comprennent par exemple une jauge de contrainte située sur une membrane au contact d'un fluide. Lorsque la pression du fluide varie, la membrane se déforme et la mesure de la variation de la résistivité de la jauge peut être reliée à la pression du fluide. Ce principe de mesure est largement utilisé mais nécessite la présence de fils pour venir lire l'évolution des propriétés de la jauge.

D'autres capteurs comprennent un matériau piézo électrique. Cependant, dans ce cas également, il est nécessaire d'avoir deux fils pour mesurer la tension générée par la pression exercée sur le matériau piézo électrique.

D'autres capteurs utilisent la technologie des MEMS (microsystèmes électromécaniques) et donc des matériaux semiconducteurs.

La présente invention propose une technologie de capteur de pression sans fil, particulièrement utile pour des mesures dans des environnements dangereux ou isolés comme c'est le cas d'un circuit de carburant ou d'une enceinte étanche du type pack batterie ou autre d'un véhicule automobile.

### Résumé de l'invention

La présente invention concerne un capteur de pression pour un circuit de fluide ou une enceinte étanche selon la revendication 1.

On comprend donc que la coopération entre les circuits résonants et de lecture est réalisée sans fil. Autrement dit, le circuit résonant n'est pas relié par des fils, ce qui est avantageux et facilite la fabrication ainsi que la maintenance du capteur. Le circuit de lecture peut quant à lui être relié par des fils à d'autres équipements électroniques et en particulier à un ordinateur de bord du véhicule.

On comprend également que l'encombrement du condensateur est faible car ses deux électrodes sont situées sur la membrane et n'occupent pas un espace important au-dessus de la membrane. Les deux électrodes suivent les déformations de la membrane et sont donc avantageusement souples et par exemple sous la forme de films ou couches fines. La disposition de la première bobine sur ou au-dessus de la membrane permet également d'optimiser l'encombrement du capteur.

Le capteur de pression selon l'invention peut comprendre une ou plusieurs des caractéristiques suivantes, prises isolément les unes des autres ou en combinaison les unes avec les autres :
-- la membrane a une forme générale plane, et par exemple de disque ;
   - le condensateur comprend une structure sandwich située sur ladite face de la membrane et comportant deux couches électroconductrices étirables séparées par une couche diélectrique, ces couches électroconductrices formant des électrodes et étant reliées respectivement aux bornes de ladite première bobine ;
   - le condensateur comprend deux électrodes planes et étirables situées sur ladite seconde face de la membrane et imbriquées l'une dans l'autre, ces électrodes étant reliées respectivement aux bornes de ladite première bobine ;
-- les première et seconde bobines ont des diamètres externes inférieurs ou égaux au diamètre externe ou à une dimension transversale maximale de la membrane ;
-- le capteur comprend un corps dans lequel est montée la membrane ;
   - le corps comprend une bride annulaire ou périphérique externe de fixation, cette bride s'étendant autour de ladite membrane et comportant des orifices de passage d'éléments de fixation ;
   - le corps comprend un boîtier monobloc comportant une partie centrale définissant ladite chambre, et deux extensions formant respectivement lesdites entrée et sortie ;
-- la partie centrale du boîtier a une forme générale cylindrique et lesdites extensions sont diamétralement opposées par rapport à un axe de la partie centrale ;
   - le corps comprend en outre un couvercle rapporté et fixé sur la partie centrale et définissant avec la membrane un espace de logement dudit circuit de lecture ;
   - la membrane a sa périphérie externe qui est serrée par la bride de fixation ou entre le couvercle et la partie centrale, de façon à ce que cette membrane assure une étanchéité ;
-- la membrane comprend une surépaisseur annulaire ou périphérique à sa périphérie externe ;
   - la seconde bobine est située sur le couvercle, ou est portée par un capot situé au-dessus du couvercle ;
   - les première et seconde bobines comprennent un axe d'enroulement commun ;
-- ledit axe d'enroulement est confondu avec un axe de la partie centrale ;
-- le circuit résonant est situé sur la face de la membrane exposée au fluide ou sur la face opposée de la membrane exposée au fluide ;
   - la partie centrale de la membrane a une épaisseur constante E1 et la partie annulaire ou périphérique de la membrane a une épaisseur constante E2 qui est supérieure à E1, et qui est par exemple au moins trois fois supérieure à E1 et au plus dix fois supérieure à E1 ;
   - la membrane comprend en outre un bourrelet annulaire ou périphérique à sa périphérie externe qui est relié à la partie annulaire ou périphérique de la membrane par un voile annulaire ou périphérique de matière d'épaisseur E3, E3 étant comprise entre E1 et E2 ;
-- le voile est intercalé entre deux rebords cylindriques coaxiaux du corps ;
   - la seconde bobine est reliée à un dispositif électronique de contrôle qui comprend un premier module configuré pour adapter une impédance du circuit RLC et un second module qui est configuré pour analyser une fréquence vectorielle ;
-- la première bobine s'étend autour d'un axe de la partie centrale.

La présente invention concerne également un circuit de fluide selon la revendication 12.

La présente invention concerne également une enceinte étanche selon la revendication 13.

La présente invention concerne encore un véhicule selon la revendication 14.

### Brève description des figures

D'autres caractéristiques et avantages de l'invention apparaitront au cours de la lecture de la description détaillée qui va suivre pour la compréhension de laquelle on se reportera aux dessins annexés dans lesquels :
[Fig. 1] la figure 1 est une vue très schématique d'un capteur de pression selon l'invention ;
[Fig. 2] la figure 2 est une vue très schématique d'un exemple de réalisation d'électrodes imbriquées pour un condensateur électrique variable d'un circuit RLC pour un capteur de pression selon l'invention ;
[Fig. 3] la figure 3 représente un circuit résonant et un circuit de lecture d'un capteur de pression selon l'invention ;
[Fig. 4] la figure 4 est une vue schématique en perspective d'un mode de réalisation d'un capteur de pression selon l'invention ;
[Fig. 5] la figure 5 est une vue schématique en coupe axiale du capteur de pression de la figure 4 ;
[Fig. 6] la figure 6 est une vue schématique partielle en perspective et en coupe d'une variante de réalisation d'un capteur de pression selon l'invention ;
[Fig. 7] la figure 7 est une vue schématique partielle en perspective et en coupe d'une variante de réalisation d'un capteur de pression selon l'invention ;
[Fig. 8] la figure 8 est une vue schématique partielle en perspective et en coupe d'une variante de réalisation d'un capteur de pression selon l'invention ;
[Fig. 9] la figure 9 est une vue schématique en perspective éclatée d'une autre variante de réalisation d'un capteur de pression selon l'invention ;
[Fig. 10] la figure 10 est une vue schématique en perspective d'une membrane du capteur de la figure 9 ;
[Fig. 11] la figure 11 est une vue en coupe selon la ligne IX-IX de la figure 9 ; [Fig. 12] la figure 12 est une vue schématique partielle et en perspective d'une enceinte étanche du type pack batterie, équipée d'une autre variante de réalisation du capteur selon l'invention ;
[Fig. 13] la figure 13 est une vue schématique en perspective du capteur de la figure 12 ;
[Fig. 14] la figure 14 est une autre vue schématique en perspective du capteur de la figure 12 ; et
[Fig. 15] la figure 15 est une vue schématique en coupe axiale du capteur de la figure 12.

### Description détaillée de l'invention

L'invention concerne un capteur de pression destiné à équiper un circuit de fluide ou une enceinte étanche en particulier d'un véhicule automobile. Le circuit de fluide est par exemple un circuit de carburant. L'enceinte étanche est par exemple un pack batterie, c'est-à-dire une boîte renfermant des cellules de batterie électrique. Ces applications du capteur selon l'invention ne sont toutefois pas limitatives, l'objet de la protection demandée étant défini par les revendications.

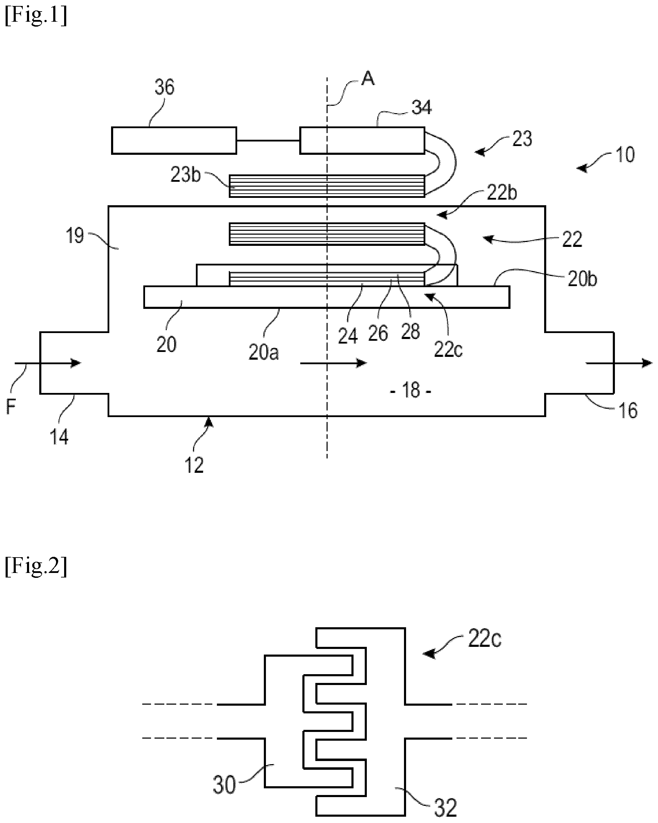

Selon des premiers modes de réalisation représentés aux figures 1 à 11, le capteur de pression 10 est destiné à équiper un circuit de fluide. Le capteur 10 comprend un corps 12, par exemple en matière plastique, qui comporte une entrée de fluide 14, une sortie de fluide 16 et une chambre interne 18 de liaison de l'entrée à la sortie de fluide en vue de l'écoulement de fluide dans le corps 12 depuis l'entrée 14 jusqu'à la sortie 16 (cf. flèches F).

Le capteur 10 comprend en outre une membrane 20 élastiquement déformable qui comporte une première face 20a destinée à être au contact du fluide s'écoulant dans le corps 12.

Dans la présente demande, on entend par « membrane », un élément sensiblement plan et élastiquement déformable. Cette membrane est réalisée en matériau élastiquement déformable tel qu'en élastomère par exemple. Comme cela sera décrit plus en détail dans ce qui suit, on utilise la propriété et en particulier l'amplitude de déformation élastique de la membrane pour pouvoir mesurer la pression du fluide circulant dans le corps.

La membrane 20 comprend donc une face 20a, ici inférieure, au contact du fluide, et comprend également une face 20b, ici supérieure.

La membrane 20 sépare la chambre 18, située par exemple sous la membrane 20, d'un espace 19 19situé au-dessus de la membrane 20.

La chambre 18 et l'espace 19 sont de préférence étanches l'une par rapport à l'autre, cette étanchéité étant de préférence assurée par la membrane 20 comme cela sera décrit dans ce qui suit.

Lors de ces déformations, la membrane 20 passe d'une position plane à une position bombée vers l'intérieur de la chambre 18, dans le cas d'une dépression dans le fluide, et vers l'intérieur de l'espace 19, dans le cas d'une surpression dans le fluide.

Le capteur de pression 10 comprend également deux circuits électroniques, respectivement résonant 22 et de lecture 23.

Le circuit résonant 22 est logé dans l'espace 19, et le circuit de lecture 23 est quant à lui situé à l'extérieur dans l'espace 19.

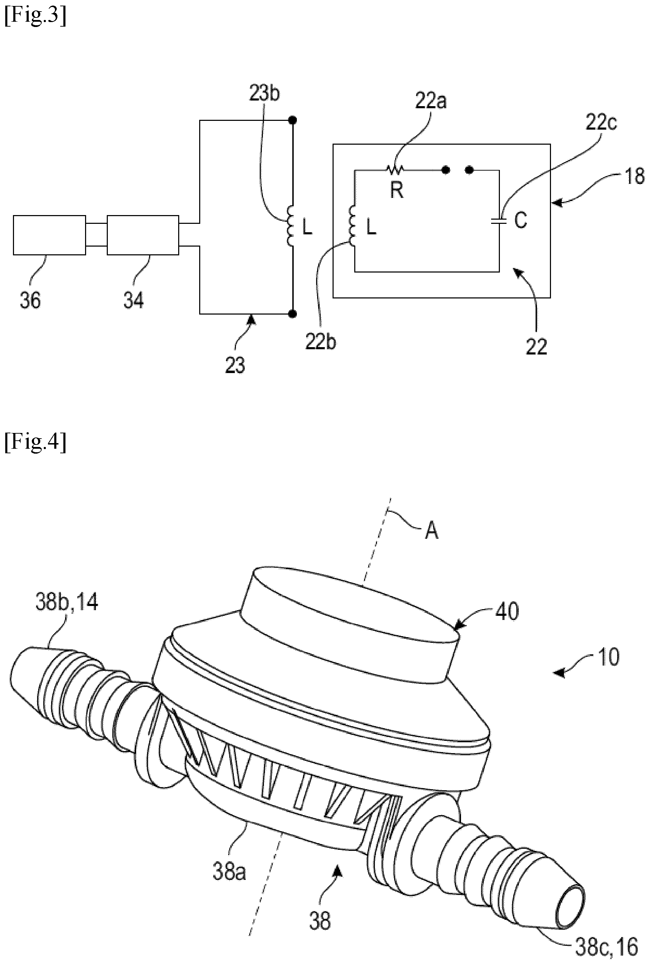

Le circuit résonant 22 est du type RLC, c'est-à-dire qu'il s'agit d'un circuit qui peut être considéré comme comprenant en série une résistance 22a (lettre R - cf. figure 3), une inductance ou une bobine 22b (lettre L) et un condensateur 22c ou une capacité (lettre C).

En pratique, le circuit résonant 22 comprend un condensateur 22c monté aux bornes d'une bobine 22b, la résistance du circuit 22 étant formée par la résistance propre de la bobine et du condensateur.

Le condensateur 22c du circuit résonant 22 est situé directement sur la membrane 20 et en particulier sur sa face 20b. Le condensateur 22c est configuré pour que sa capacité varie en fonction de l'amplitude de déformation élastique de la membrane 20. Selon la configuration du condensateur 22c, plus l'amplitude de la déformation est importante, et plus la capacité du condensateur peut être forte, ou inversement faible.

Selon l'invention, le condensateur 22c comprend deux électrodes qui sont reliées respectivement aux bornes de ladite première bobine 22b et qui sont toutes les deux situées sur la face 20b de la membrane 20 de façon à ce qu'elles puissent suivre toutes les deux les déformations élastiques de la membrane.

Les électrodes sont avantageusement souples et donc déformables. Elles peuvent se présenter sous la forme de films ou couches.

Selon une première configuration, le condensateur 22c comprend une structure sandwich visible à la figure 1 qui est située sur la face 20b et qui comporte deux électrodes ou couches électroconductrices 24, 28 étirables séparées par une couche diélectrique 26. Les couches électroconductrices 24, 28 forment des électrodes et sont reliées respectivement aux bornes de la bobine 22b.

Selon une autre configuration visible à la figure 2, le condensateur 22c comprend deux électrodes 30, 32 planes et étirables situées sur la face 20b et imbriquées ou interdigitées l'une dans l'autre, ces électrodes étant reliées respectivement aux bornes de ladite première bobine 22b.

Dans chacune de ces configurations, le condensateur 22c est de préférence protégée par une couche de passivation déposée sur le condensateur 22c et au moins une partie de la face 20b.

La bobine 22b a de préférence une forme annulaire ou cylindrique et s'étend autour d'un axe A qui est de préférence centrée sur la membrane 20. Autrement dit, la bobine 22b et la membrane 20 sont coaxiales.

Par ailleurs, la bobine 22b a de préférence un diamètre externe inférieur au diamètre externe ou à la dimension transversale maximale de la membrane 20.

Comme cela est visible à la figure 1, la bobine 22b peut être située au-dessus de la membrane 20 mais pourrait aussi être située sur la membrane 20 et en particulier sa face 20b.

Le circuit de lecture 23 comporte une autre bobine 23b qui est de préférence située en face de la première bobine 22b et configurée pour détecter la fréquence de résonance du circuit résonant 22 et émettre un signal de lecture en conséquence.

La bobine 23b a de préférence une forme annulaire ou cylindrique et s'étend autour de l'axe A. Elle est donc de préférence centrée sur la bobine 22b et la membrane 20.

Par ailleurs, la bobine 23b a de préférence un diamètre externe inférieur au diamètre externe ou à la dimension transversale maximale de la membrane 20, et qui est de préférence identique au diamètre externe de la bobine 22b.

La bobine 23b est située au-dessus de la bobine 22b et ses bornes sont reliées à un dispositif électronique de contrôle qui comprend un premier module 34 configuré pour adapter l'impédance de l'antenne de lecture (c'est-à-dire de la bobine 23b) et un second module 36 qui est configuré pour suivre la variation de la fréquence de résonance du circuit 22, comme cela est représenté aux figures 1 et 3.

Le module 34 permet d'adapter l'impédance de l'antenne de lecture de façon à ce que toute l'énergie envoyée soit émise (c'est-à-dire en minimisant la réflexion). Ce module 34 peut été composé de condensateur(s) et d'inductance(s) montés en série ou parallèle selon les besoins.

Le module 36 est un analyseur vectoriel de fréquence. Il effectue un balayage en fréquence sur une plage donnée, ce qui permet de suivre l'évolution de la fréquence de résonance du circuit.

Le capteur de pression 10 selon l'invention fonctionne de la façon suivante. Sous l'effet de la déformation de la membrane 20 liée à la pression du fluide, la valeur de la capacité du condensateur 22c varie provoquant ainsi une modification de la fréquence de résonance du circuit résonant 22. Le décalage de cette fréquence de résonance est proportionnel à la pression exercée par le fluide.

En pratique, un étalonnage du capteur de pression 10 peut être nécessaire pour déterminer la fonction de transformation de la variation en pression par rapport au décalage fréquentiel.

Les figures 4 à 11 représentent des modes plus concrets de réalisation d'un capteur de pression 10 selon l'invention.

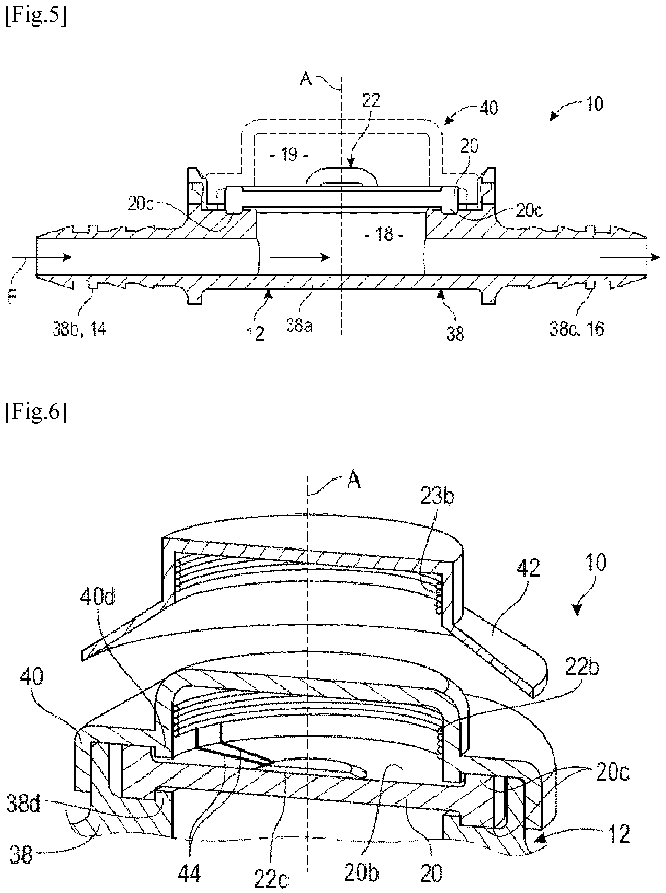

Dans le mode de réalisation des figures 4 et 5, le corps 12 du capteur 10 comprend un boîtier 38 monobloc comportant une partie centrale 38a définissant la chambre 18, et deux extensions 38b, 38c formant respectivement les entrée 14 et sortie 16.

La partie centrale 38a du boîtier 38 a une forme générale cylindrique d'axe A et les extensions 38b, 38c sont diamétralement opposées par rapport à cet axe A.

Le corps 12 comprend en outre un couvercle 40 rapporté et fixé sur la partie centrale 38a et définissant l'espace 19 dans laquelle est situé le circuit résonant 22.

La membrane 20 sépare 19la chambre 18 de l'espace 19 et sa périphérie externe est serrée entre le couvercle 40 et la partie centrale 38a. La membrane 20 assure alors l'étanchéité entre 19la chambre 18 et l'espace 19. La périphérie externe de la membrane 20 peut comprendre une surépaisseur annulaire 20c destinée à être comprimée axialement de façon à garantir une étanchéité jusqu'à une pression suffisante largement supérieure à la pression maximale que peut atteindre le fluide circulant dans la chambre 18.

La membrane 20 a de préférence une forme générale plane, et par exemple de disque, et peut avoir un diamètre externe ou une dimension transversale compris entre 10 et 50mm, et de préférence entre 20 et 40mm. En variante, elle pourrait avoir une autre forme.

Elle a une épaisseur minimale comprise entre 1 et 3mm et une épaisseur maximale à sa périphérie externe comprise entre 3 et 8mm, et de préférence entre 4 et 7mm.

Les figures 6 à 8 illustrent des variantes de réalisation du capteur de pression 10.

Dans la figure 6, la bobine 23b du circuit de lecture est portée par un capot 42 qui est disposé au-dessus du couvercle 40 et à distance de ce dernier. La bobine 23b est logée dans un renfoncement de ce capot et protégée ainsi par le capot.

La bobine 22b du circuit résonant 22 est disposée au-dessus de la membrane 20 et est portée par le couvercle 40 du corps 12 du capteur 10. Des fils 44 relient les bornes de la bobine 22b au condensateur 22c situé sur la face 20b de la membrane 20.

Dans ce qui suit, l'expression « annulaire » peut faire référence à un élément ou une partie de la membrane en forme générale de disque. Dans le cas où la membrane n'aurait pas exactement une telle forme, « annulaire » devrait être interprétée comme « périphérique » par exemple.

La surépaisseur annulaire 20c de la membrane 20 est intercalée entre le couvercle 40 et le boîtier 38 du corps 12. Le boîtier 38 et le couvercle 40 comprennent des rebords cylindriques 38d, 40d qui s'étendent autour de l'axe A, en regard l'un de l'autre, et entre lesquels est intercalée la membrane 20.

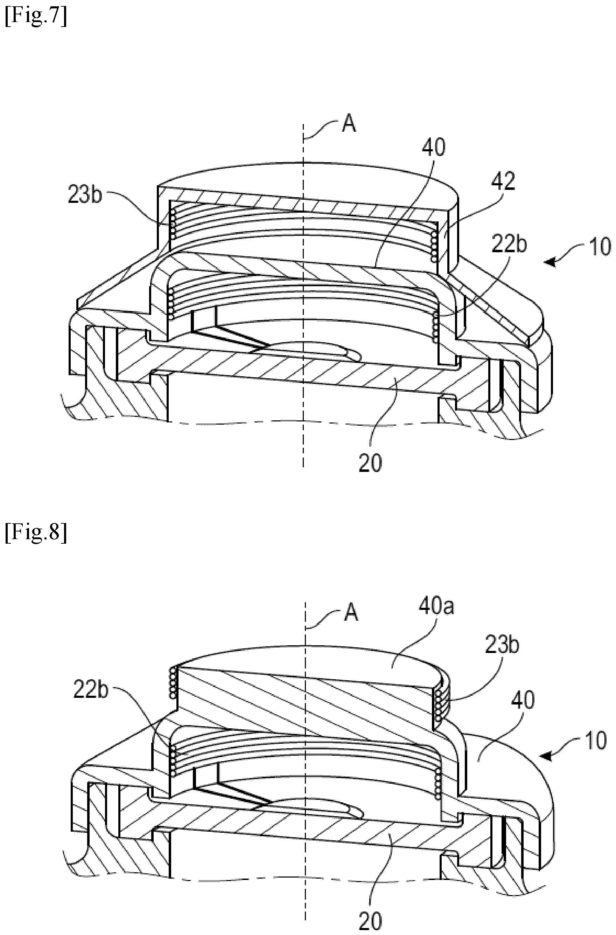

La variante de réalisation de la figure 7 diffère de celle de la figure 5 en ce que le capot 42 est directement posé et peut être fixé sur le couvercle 40. Il n'y a donc pas de distance ou jeu entre le capot 42 et le couvercle 40.

La variante de réalisation de la figure 8 diffère de celles des figures 5 et 6 en ce qu'elle ne comprend pas de capot. La bobine 23b est portée par le couvercle 40 et s'étend dans l'exemple représenté autour d'un prolongement cylindrique 40a du couvercle 40 le long de l'axe A.

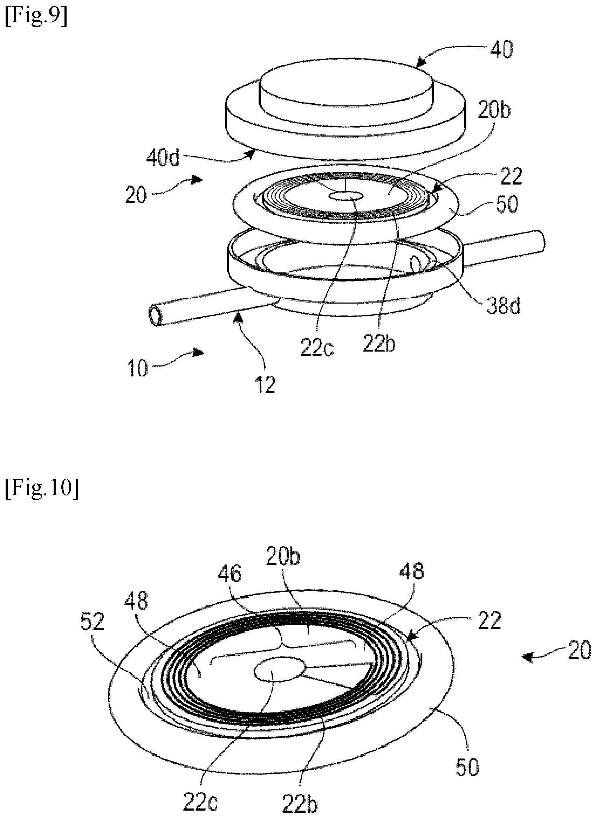

On se réfère désormais aux figures 9 à 11 qui illustrent une autre variante de réalisation d'un capteur de pression 10 selon l'invention.

Cette variante diffère des précédents modes de réalisation essentiellement par sa membrane 20 et son circuit résonant 22.

L'intégralité du circuit résonant 22 est située sur la face 20b de la membrane 20. Le condensateur 22c du circuit résonant 22 est situé sur une partie centrale 46 de la membrane 20, et la bobine 22b est située sur une partie annulaire 48 de la membrane 20 s'étendant autour de la partie centrale 46

La partie centrale 46 de la membrane 20 a une épaisseur constante E1 et sa partie annulaire 48 a une épaisseur constante E2 qui est supérieure à E1, et qui est par exemple au moins trois fois voire cinq fois supérieure à E1. E2 est de préférence au plus dix fois supérieure à E1.

La membrane 20 comprend en outre un bourrelet annulaire 50 à sa périphérie externe qui est relié à la partie annulaire 48 de la membrane 20 par un voile annulaire 52 de matière d'épaisseur E3. E3 est comprise entre E1 et E2.

Comme cela est visible à la figure 9, ce voile 52 est intercalé entre les deux rebords cylindriques 38d (le rebord 40d du couvercle 40 n'est pas visible) précités du boîtier 38 et du couvercle 40, respectivement.

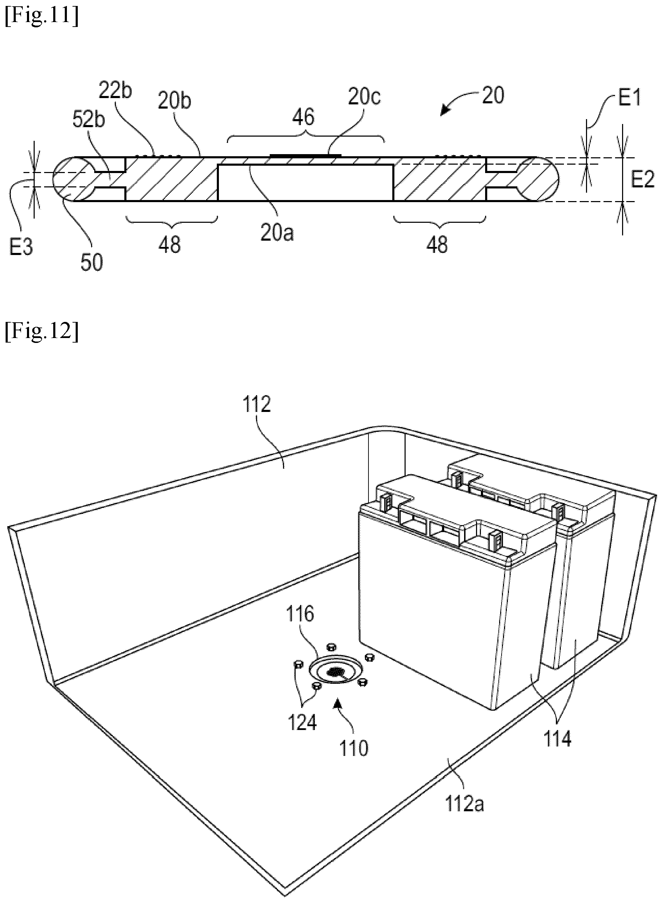

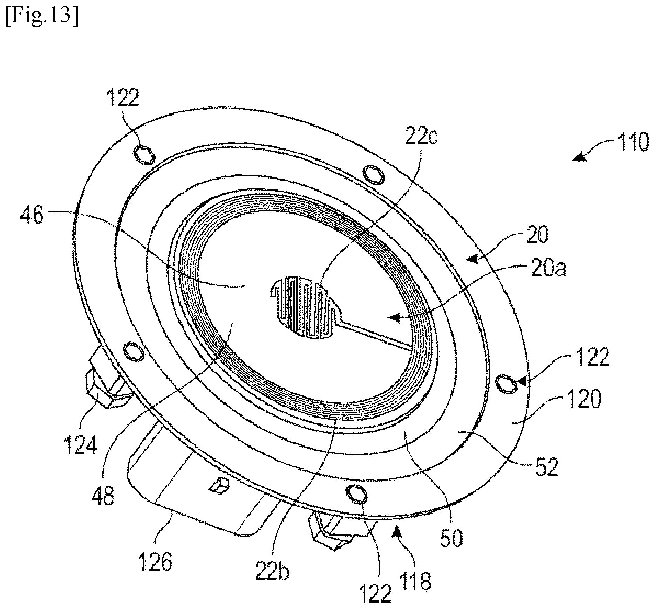

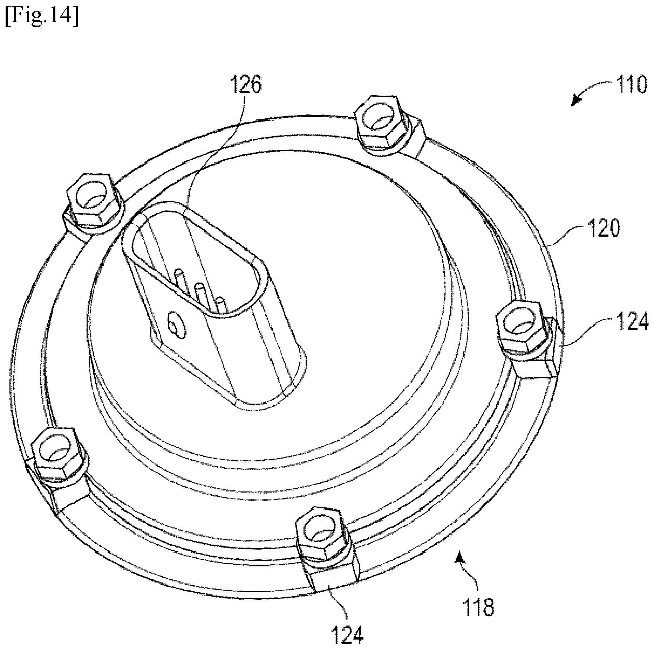

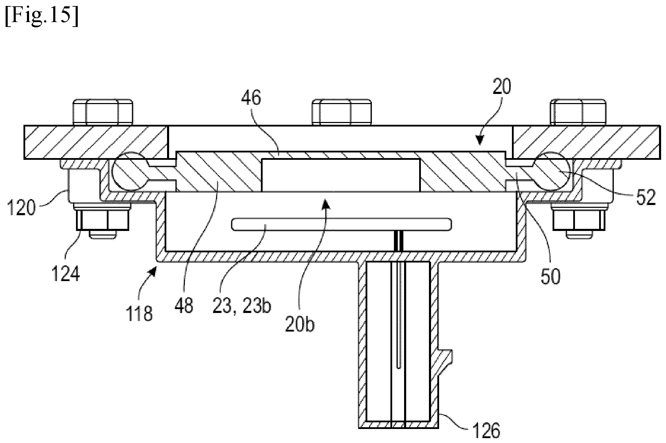

Les figures 12 à 15 illustrent une autre variante de réalisation du capteur 110 selon l'invention qui est ici destiné à équiper une enceinte étanche du type pack batterie.

L'enceinte ou le pack batterie est partiellement représenté à la figure 12 et comprend une boîte 112 dans laquelle sont logées des cellules de batterie 114 dont seulement deux sont représentées pour plus de clarté.

Les cellules de batterie 114 sont enfermées dans la boîte 112 qui est étanche. En cas de dysfonctionnement d'au moins une des cellules 114, celle-ci peut chauffer et produire un gaz à l'intérieur de la boîte 112. Du fait de la nature étanche de l'enceinte, ce gaz va augmenter la pression interne de l'enceinte et le capteur de pression 110 est destiné à détecter cette montée en pression et donc à détecter le dysfonctionnement de la cellule.

La boîte 112 comprend une paroi 112a comportant un trou 116 traversant au niveau duquel est monté le capteur 110. Dans l'exemple représenté, le trou 116 et le capteur 110 sont sensiblement situés au milieu de cette paroi 112a. Le capteur 110 est rapporté depuis l'extérieur sur le trou 116 de façon à le fermer de manière étanche.

Le capteur 110 est similaire à celui décrit dans ce qui précède dans la mesure où il comprend une membrane 20 équipée d'un circuit résonant 22. Toutefois, contrairement au capteur 10, le circuit résonant 22 du capteur 110 est ici située sur la face 20a destinée à être exposé au fluide (gaz) et donc située du côté de l'intérieur de l'enceinte.

Le capteur 110 est fixé par des moyens de fixation appropriés sur la paroi 112a.

Le capteur 110 comprend ici un corps 118 qui comprend une bride annulaire externe de fixation 120. Cette bride 120 s'étend autour de la membrane 20 et comporte des orifices 122 alignés avec des orifices de la paroi 112a pour le passage d'éléments de fixation 124 du type vis-écrou.

Le corps 118 définit avec la face 20b de la membrane 20, opposée à la face 20a, un espace de logement du circuit de lecture 23.

Le corps 118 comprend ici une fiche 126 de raccordement électrique qui permet le raccordement électrique du circuit de lecture 23 au dispositif électronique de contrôle et en particulier au(x) module(s) 34, 36.

Le matériau de la membrane 20 est de préférence un élastomère et est par exemple du HNBR.

La membrane 20 peut avoir une ou plusieurs des caractéristiques suivantes :
- une résistance à la traction comprise entre 10 et 40MPa,
- une dureté DIDC comprise entre 50 et 100pts,
- un allongement à la rupture compris entre 100 et 600%, et de préférence entre 200 et 500%.

## Revendications

1. Capteur de pression (10, 110) pour un circuit de fluide ou une enceinte étanche, en particulier d'un véhicule automobile, le capteur comportant :
- une membrane (20) élastiquement déformable comportant deux faces (20a, 20b) opposées dont une est destinée à être au contact d'un fluide,
- un circuit résonant (22) du type RLC comportant un condensateur (22c) qui est situé sur l'une des faces (20a, 20b) de la membrane, et dont la capacité varie en fonction de l'amplitude de déformation élastique de ladite membrane, et une première bobine (22b) qui est reliée audit condensateur, ledit circuit résonant étant configuré pour avoir une fréquence de résonance qui varie en fonction de la capacité du condensateur et donc de la déformation élastique de la membrane, le condensateur (22c) comprenant deux électrodes qui sont reliées respectivement aux bornes de ladite première bobine (22b), et
- un circuit de lecture (23) déporté par rapport à la membrane et comportant une seconde bobine (23b) située en face de la première bobine (22b) et configurée pour détecter la fréquence de résonance dudit circuit résonant et émettre un signal de lecture en conséquence, l'intégralité du circuit résonant (22) étant située sur ladite face de la membrane (20), le condensateur (22c) du circuit résonant étant située sur une partie centrale (46) de la membrane,
**caractérisé en ce que** les deux électrodes sont toutes les deux situées sur la face de la membrane (20) de façon à ce qu'elles suivent toutes les deux la déformation élastique de la membrane (20), et ladite première bobine (22b) est située sur cette face de la membrane (20), sur une partie annulaire (48) ou périphérique de la membrane s'étendant autour de la partie centrale précitée.

2. Capteur (10, 110) selon la revendication 1, dans lequel le condensateur (22c) comprend une structure sandwich située sur ladite face de la membrane et comportant deux couches électroconductrices (24, 28) étirables séparées par une couche diélectrique (26), ces couches électroconductrices (24, 28) formant lesdites électrodes.

3. Capteur (10, 110) selon la revendication 1, dans lequel lesdites électrodes (30, 32) sont planes, étirables sur ladite face de la membrane, et imbriquées l'une dans l'autre.

4. Capteur (10, 110) selon l'une des revendications précédentes, dans lequel il comprend en outre un corps (12, 118) dans lequel est montée la membrane (20).

5. Capteur (10) selon la revendication 4, dans lequel le corps (12) comprend une entrée de fluide (14), une sortie de fluide (16), et une chambre interne (18) de liaison de l'entrée à la sortie de fluide en vue de l'écoulement de fluide dans ledit corps, ledit circuit de lecture (23) étant situé à l'extérieur de la chambre (18) et étant séparée de cette chambre par ladite membrane (20).

6. Capteur (10) selon la revendication 5, dans lequel le corps (12) comprend un boîtier (38) monobloc comportant une partie centrale (38a) définissant ladite chambre (18), et deux extensions (38a, 38b) formant respectivement lesdites entrée (14) et sortie (16).

7. Capteur (10) selon la revendication 6, dans lequel le corps (12) comprend en outre un couvercle (40) rapporté et fixé sur la partie centrale (38a) et définissant avec la membrane (20) un espace (19) de logement dudit circuit de lecture (23), et en ce que la seconde bobine (23b) est située dans le corps (118), sur le couvercle (40), ou est portée par un capot (42) situé au-dessus du couvercle.

8. Capteur (10, 110) selon l'une des revendications précédentes, dans lequel les première et seconde bobines (22b, 23b) comprennent un axe d'enroulement commun.

9. Capteur (10, 110) selon l'une des revendications précédentes, dans lequel la partie centrale (46) de la membrane (20) a une épaisseur constante E1 et la partie annulaire (48) ou périphérique de la membrane a une épaisseur constante E2 qui est supérieure à E1, et qui est par exemple au moins trois fois supérieure à E1 et au plus dix fois supérieure à E1.

10. Capteur (10, 110) selon l'une des revendications précédentes, dans lequel la membrane (20) comprend en outre un bourrelet annulaire (50) ou périphérique à sa périphérie externe qui est relié à la partie annulaire (48) ou périphérique de la membrane par un voile annulaire ou périphérique de matière (52) d'épaisseur E3, E3 étant comprise entre E1 et E2.

11. Capteur (10, 110) selon l'une des revendications précédentes, dans lequel la seconde bobine (23b) est reliée à un dispositif électronique de contrôle qui comprend un premier module (34) configuré pour adapter une impédance du circuit RLC et un second module (36) qui est configuré pour analyser une fréquence vectorielle.

12. Circuit de fluide, en particulier pour un véhicule automobile, comportant au moins un capteur (10) selon l'une des revendications précédentes.

13. Enceinte étanche telle qu'un pack batterie, en particulier pour un véhicule automobile, comportant au moins un capteur (110) selon l'une des revendications 1 à 11.

14. Véhicule, en particulier automobile, comportant au moins un capteur (10) selon l'une des revendications 1 à 11, un circuit selon la revendication 12 ou une enceinte étanche selon la revendication 13.

## Patentansprüche

1. Drucksensor (10,110) für einen Fluidkreislauf oder ein dichtes Gehäuse, insbesondere eines Kraftfahrzeugs, wobei der Sensor umfasst:
- eine elastisch verformbare Membran (20), welche zwei gegenüberliegende Seiten (20a, 20b) umfasst, von der eine dazu bestimmt ist, in Kontakt mit einem Fluid zu sein,
- eine Resonanzschaltung (22) in der Art RLC, welche einen Kondensator (22c) umfasst, der sich auf einer der Seiten (20a, 20b) der Membran befindet, und dessen Kapazität je nach Amplitude der elastischen Verformung der Membran variiert, und eine erste Spule (22b), welche an den Kondensator angeschlossen ist, wobei die Resonanzschaltung konfiguriert ist, um eine Resonanzfrequenz aufzuweisen, welche je nach Kapazität des Kondensators, und somit der elastischen Verformung der Membran variiert, wobei der Kondensator (22c) zwei Elektroden umfasst, welche jeweils an die Klemmen der Spule (22b) angeschlossen sind, und
- eine in Bezug auf die Membran ausgelagerte Leseschaltung (23), und eine zweite Spule (23b) umfassend, welche sich gegenüber der ersten Spule (22b) befindet, und konfiguriert, um die Resonanzfrequenz der Resonanzschaltung zu erkennen, und dementsprechend ein Lesesignal auszugeben, wobei sich die Gesamtheit der Resonanzschaltung (22) auf der Seite der Membran (20) befindet, wobei sich der Kondensator (22c) der Resonanzschaltung in einem zentralen Teil (46) der Membran befindet,
**dadurch gekennzeichnet, dass** sich die beiden Elektroden alle beide auf der Seite der Membran (20) befinden, sodass sie alle beide der elastischen Verformung der Membran (20) folgen, und sich die erste Spule (22b) auf dieser Seite der Membran (20), auf einem ringförmigen oder umfänglichen Teil (48) der Membran befindet, der sich um den zuvor genannten zentralen Teil erstreckt.

2. Sensor (10, 110) nach Anspruch 1, wobei der Kondensator (22c) eine SandwichStruktur umfasst, welche sich auf der Seite der Membran befindet, und zwei dehnbare elektrisch leitfähige Schichten (24, 28) umfasst, die durch eine dielektrische Schicht (26) getrennt sind, wobei diese elektrisch leitfähigen Schichten (24,28) die Elektroden bilden.

3. Sensor (10, 110) nach Anspruch 1, wobei die Elektroden (30, 32) eben, auf der Seite der Membran dehnbar, und ineinander verschachtelt sind.

4. Sensor (10, 110) nach einem der vorstehenden Ansprüche, wobei er weiter einen Körper (12, 118) umfasst, in dem die Membran (20) angebracht ist.

5. Sensor (10) nach Anspruch 4, wobei der Körper (12) einen Fluideinlass (14), einen Fluidauslass (16), und eine innere Kammer (18) zur Verbindung des Fluideinlasses mit dem Auslass zum Strömen des Fluids in dem Körper umfasst, wobei sich die Leseschaltung (23) außerhalb der Kammer (18) befindet, und durch die Membran (20) von dieser Kammer getrennt ist.

6. Sensor (10) nach Anspruch 5, wobei der Körper (12) ein einteiliges Gehäuse (38) umfasst, welches einen zentralen Teil (38a) umfasst, welcher die Kammer (18) definiert, und zwei Erweiterungen (38a, 38b), welche jeweils den Einlass (14) und Auslass (16) bilden.

7. Sensor (10) nach Anspruch 6, wobei der Körper (12) weiter einen Deckel (40) umfasst, welcher auf dem zentralen Teil (38a) beigebracht und befestigt ist, und mit der Membran (20) einen Raum (19) zur Aufnahme der Leseschaltung (23) definiert, und dadurch, dass sich die zweite Spule (23b) in dem Körper (118), auf dem Deckel (40) befindet, oder von einer Abdeckung (42) getragen wird, welche sich oberhalb des Deckels befindet.

8. Sensor (10, 110) nach einem der vorstehenden Ansprüche, wobei die erste und zweite Spule (22b, 23b) eine gemeinsame Wickelachse umfassen.

9. Sensor (10, 110) nach einem der vorstehenden Ansprüche, wobei der zentrale Teil (46) der Membran (20) eine konstante Dicke E1 aufweist, und der ringförmige oder umfängliche Teil (48) der Membran eine konstante Dicke E2 aufweist, welche größer als E1 ist, und welche beispielsweise mindestens dreimal größer als E1, und höchstens zehnmal größer als E1 ist.

10. Sensor (10, 110) nach einem der vorstehenden Ansprüche, wobei die Membran (20) weiter einen ringförmigen oder umfänglichen Wulst (50) an ihrem Außenumfang umfasst, welcher durch einen ringförmigen oder umfänglichen Schleier aus einem Material (52) mit einer Dicke E3 an den ringförmigen oder umfänglichen Teil (48) der Membran angeschlossen ist, wobei E3 zwischen E1 und E2 liegt.

11. Sensor (10, 110) nach einem der vorstehenden Ansprüche, wobei die zweite Spule (23b) an eine elektronische Steuervorrichtung angeschlossen ist, welche ein erstes Modul (34) umfasst, konfiguriert, um eine Impedanz der RLC-Schaltung anzupassen, und ein zweites Modul (36), welches konfiguriert ist, um eine Vektorfrequenz zu analysieren.

12. Fluidkreislauf, insbesondere für ein Kraftfahrzeug, welcher mindestens einen Sensor (10) nach einem der vorstehenden Ansprüche umfasst.

13. Dichtes Gehäuse, wie ein Batterie-Pack, insbesondere für ein Kraftfahrzeug, welches mindestens einen Sensor (110) nach einem der Ansprüche 1 bis 11 umfasst.

14. Fahrzeug, insbesondere Kraftfahrzeug, welches mindestens einen Sensor (10) nach einem der Ansprüche 1 bis 11, einen Kreislauf nach Anspruch 12 oder ein dichtes Gehäuse nach Anspruch 13 umfasst.

## Claims

1. A pressure sensor (10, 110) for a fluid circuit or a sealed enclosure, in particular of a motor vehicle, the sensor comprising:
- an elastically deformable membrane (20) comprising two opposite faces (20a, 20b), one of which is intended to be in contact with a fluid,
- a resonant circuit (22) of the RLC type comprising a capacitor (22c) which is located on one of the faces (20a, 20b) of the membrane, and whose capacitance varies as a function of the amplitude of elastic deformation of said membrane, and a first coil (22b) which is connected to said capacitor, said resonant circuit being configured to have a resonant frequency which varies as a function of the capacitance of the capacitor and therefore of the elastic deformation of the membrane, the capacitor (22c) comprising two electrodes which are connected respectively to the terminals of said first coil (22b), and
- a readout circuit (23) offset from the membrane and comprising a second coil (23b) located opposite the first coil (22b) and configured to detect the resonant frequency of said resonant circuit and to emit a readout signal accordingly,
the entirety of the resonant circuit (22) being located on said face of the membrane (20), the capacitor (22c) of the resonant circuit being located on a central part (46) of the membrane,
**characterised in that** the two electrodes are both located on the face of the membrane (20) so that they both follow the elastic deformation of the membrane (20), and said first coil (22b) is located on that face of the membrane (20), on an annular or peripheral part (48) of the membrane extending around the abovementioned central part.

2. The sensor (10, 110) according to claim 1, wherein the capacitor (22c) comprises a sandwich structure located on said face of the membrane and comprising two stretchable electroconductive layers (24, 28) separated by a dielectric layer (26), these electroconductive layers (24, 28) forming said electrodes.

3. The sensor (10, 110) of claim 1, wherein said electrodes (30, 32) are planar, stretchable on said face of the membrane, and interleaved with each other.

4. The sensor (10, 110) according to one of the preceding claims, wherein it further comprises a body (12, 118) in which the membrane (20) is mounted.

5. The sensor (10) according to claim 4, wherein the body (12) comprises a fluid inlet (14), a fluid outlet (16), and an internal chamber (18) for connecting the inlet to the fluid outlet for the fluid flow in said body, said readout circuit (23) being located outside the chamber (18) and being separated from that chamber by said membrane (20).

6. The sensor (10) according to claim 5, wherein the body (12) comprises a one-piece casing (38) comprising a central part (38a) defining said chamber (18), and two extensions (38a, 38b) forming said inlet (14) and outlet (16) respectively.

7. The sensor (10) according to claim 6, wherein the body (12) further comprises a lid (40) attached and fixed to the central part (38a) and defining with the membrane (20) a space (19) for housing said readout circuit (23), and in that the second coil (23b) is located in the body (118), on the lid (40), or is carried by a cover (42) located above the lid.

8. The sensor (10, 110) according to one of the preceding claims, wherein the first and second coils (22b, 23b) comprise a common winding axis.

9. The sensor (10, 110) according to any one of the preceding claims, wherein the central part (46) of the membrane (20) has a constant thickness E1 and the annular or peripheral part (48) of the membrane has a constant thickness E2 which is greater than E1, and which is for example at least three times greater than E1 and at most ten times greater than E1.

10. The sensor (10, 110) according to any one of the preceding claims, wherein the membrane (20) further comprises an annular or peripheral bead (50) at its outer periphery which is connected to the annular or peripheral part (48) of the membrane by an annular or peripheral web of material (52) of thickness E3, E3 being between E1 and E2.

11. The sensor (10, 110) according to one of the preceding claims, wherein the second coil (23b) is connected to an electronic control device which comprises a first module (34) configured to adjust an impedance of the RLC circuit and a second module (36) which is configured to analyse a vector frequency.

12. A fluid circuit, in particular for a motor vehicle, comprising at least one sensor (10) according to one of the preceding claims.

13. A sealed enclosure such as a battery pack, in particular for a motor vehicle, comprising at least one sensor (110) according to one of claims 1 to 11.

14. A vehicle, in particular an automobile, comprising at least one sensor (10) according to one of claims 1 to 11, a circuit according to claim 12 or a sealed enclosure according to claim 13.
